# EUROPEAN PATENT APPLICATION

(11) **EP 2 451 256 A1**
(43) Date of publication of application: **09.05.2012**
(21) Application number: 10190505.7
(22) Date of filing: 09.11.2010
(51) Int. Cl.: H05K 3/12

(54) **Printed circuit board screen printing device and method**

(71) Applicant: RRo Holding B.V., 3016 AJ Rotterdam (NL)
(72) Inventor: Roelvink, Hendrik Gerard, 3016 AJ Rotterdam (NL); Stans, Dirk, 2450 Meerhout (BE); Bots, Harrie, 3023 HB Rotterdam (NL)
(74) Representative: Jansen, Cornelis Marinus

(57) **Abstract**

A screen printing device is used to printing solder paste on a printed circuit board (PCB) through a printing screen. The PCB is supported on at least one printed circuit board support block on a platform. A plurality of protrusions and/or indentations on an upper surface of the support block. A plurality of corresponding protrusions and/or indentations is provided on the printing screen. The printing screen is placed in a frame and subsequently moved the relative to the frame when the frame is in a printing position, until the protrusions and/or indentations on the printing screen engage the indentations and/or protrusions on said at least one printed circuit board support block. The printing screen is then fixed in the frame for use to print material on the PCB.

## Description

### Field of the invention

The invention relates to a screen printing device for printing on printed circuit boards and a method of printing on printed circuit boards.

### Background

A printed circuit board comprises a substrate and at least one, but usually a plurality of interconnected conductor layers that together form the connection network, the wiring, between the electronic components that will be placed on the circuit board. The components need to be soldered onto the board applying solder and heating to secure the joint. For soldering ever shrinking components onto ever smaller pads, great accuracy of the application of solder paste on the pads is required. Solder paste must be accurately aligned with the pattern of solder pads on the circuit board.

It is known to apply solder paste to printed circuit boards by screen printing. Screen printing involves pushing matter through openings in a screen onto a printed circuit board. The position of the openings in the screen needs to be very accurately aligned with the position of the solder pads on the circuit board that will be receiving the printed matter, in this case solder paste. But the same principle can also be applied also to inks for example.

Known screen printing devices operate on a frame in which a screen is mounted and a platform on which a printed circuit board can be placed. The frame and the platform are aligned relative to each other. The frame can be moved away from the platform to allow the circuit board to be replaced by another one after printing.

Typically, printed circuit board printing is performed by specialized manufacturers, which receive screens from many external designers, for use in the same screen printing device. For each series of printed circuit boards or for different prints on one printed circuit board, different screens need to be mounted in the same frame. When this is done, the screen needs to be positioned relative to the frame in order to ensure alignment with the printed circuit board. Conventionally, the frame is provided with adjustment controls to do so. To align the screen in the frame, an operator places a sample printed circuit board on the platform, moves the frame to a position where the screen is over the sample printed circuit board and adjusts the controls until visual inspection shows that the screen is properly aligned with the printed circuit board. Subsequently the screen may be used to print on the rest of the series of printed circuit boards.

This procedure has the problem that it requires a time consuming adjustment by the operator, which highly depends on the skills of the operator. The designer of the printed circuit board has no control over the alignment, unless the designer performs printing in-house.

### Summary

Among others, it is an object to provide for a better control over alignment of screens and printed circuit boards during screen printing on printed circuit boards.

A method of printing material on a printed circuit board according to claim 1 is provided. Herein matching protrusions and indentations on a printing screen and one or more support blocks on the platform are used to position the printing screen in the frame before printing. The printing screen may have pins extending from the printing screen and the support blocks may have holes for receiving the pins for example. One support block with a plurality of protrusions and/or indentations may be used, or a plurality of support blocks, each with at least one protrusion and/or indentations. The printing screen and the frame are moved to a printing position. The printing screen is repositioned relative to the frame until the matching protrusions and indentations are engaged and then the printing screen is fixed relative to the frame. Printing screens are provided wherein the pattern on the printing screen is provided in alignment with the protrusions and indentations on the printing screen. In this way, no visual inspection is needed to fix the printing screen. It suffices to move the printing screen until the matching protrusions and indentations are engaged.

According to another aspect a printed circuit board printing device according to claim 2 is provided. The device comprises the platform, at least one printed circuit board support block on the platform to define a first location of a printed circuit board and a frame configured to hold a printing screen at a second location over said first location. The frame exposes the printing screen exposed to the plurality of protrusions and/or indentations. The frame has fixation means for fixing a printing screen relative to the frame, the frame providing for repositioning of the printing screen in the frame when not fixed by said fixation means. In this way, no visual inspection is needed to fix the printing screen.

In an embodiment the at least one printed circuit board support block has a support surface for supporting a printed circuit board to be printed and a further plurality of further protrusions and/or indentations on said support surface, for engagement with corresponding further indentations and/or protrusions on the printed circuit board. In this way the position of the PCB relative to the support blocks, and therefore relative to the printing screen can easily be defined. Alternatively, or in addition, positioning of the PCB against stops may be used to define the position of the PCB. However, the use of further protrusions and/or indentations has the advantage that a more stable position of the PCB relative to the printing screen is realized.

In an embodiment the frame defines a window for exposing the printing screen, the frame comprising a slot opening towards the window, for receiving an end portion of the printing screen, the slot having a dimension that allows for said repositioning of the printing screen within the slot. The slots allow for robust prepositioning of the printing screen and controlled movement of the printing screen in one or more directions in the plane of the slot during repositioning.

The printing screen may be exchangeable. A plurality of different printing screens may be mounted alternately in the printing device.

In an embodiment the at least one printed circuit board support block comprise a first and second printed circuit board support block, each comprising at least one of the plurality of protrusions and/or indentations. Thus position and rotation of the printing screen can be defined using the first and second support block. The first and second printed circuit board support block may each comprise a hole for receiving a pin that extends from the printing screen in a printing position of the device, in order to position the printing screen. Alternatively pins may be used that extend from the support blocks through the printing screen. However, it has been found that the use of holes in the support blocks result in less wear.

In an embodiment the first and second printed circuit board support block are moveable relative to each other on the platform. This makes it possible to adapt the positions of the protrusions and/or indentations to different printing sheets. The support blocks may be detachable from the platform. This increases the positioning freedom. The support blocks may have a stop ridge to provide for accurate positioning of the support blocks against an edge of the platform. In an embodiment, one or more support blocks comprise a magnet for magnetically fixing the detachable support block or blocks to the platform. It has been found that flexible and reliable positioning is possible in this way.

The frame and the platform may be movable relative to each other, between a printing position and a PCB loading position. The frame may be hinged to a bed that supports the platform for example, so that the frame can be rotated between the printing position and the loading position.

In an embodiment the device has alignment means for aligning the platform with the frame. The alignment means engage when the frame is brought to a printing position. Preferably these alignment means are outside the support blocks, and this distinct from the protrusions and./or indentations on. Support posts may be used for example. Thus the forces involved with engagement are handled without involving the support blocks or their positioning. A lifting mechanism may be used to move the platform with the support blocks and a PCB towards the printing screen after the alignment means have engaged. Specially designed printing screens may be used with pins extending from the main surface of the printing screen (the surface through which printing material is applied) at well defined positions relative to the printing pattern on the printing screen.

### Brief description of the drawing

These and other object and advantageous aspects will become apparent from a description of exemplary embodiments, using the following figures
Figure 1a, b show first side views of a screen printing device
Figure 2a, b show further views of a screen printing device
Figure 3 shows a support block
Figure 4 shows a detail of a printing screen

### Detailed description of exemplary embodiments

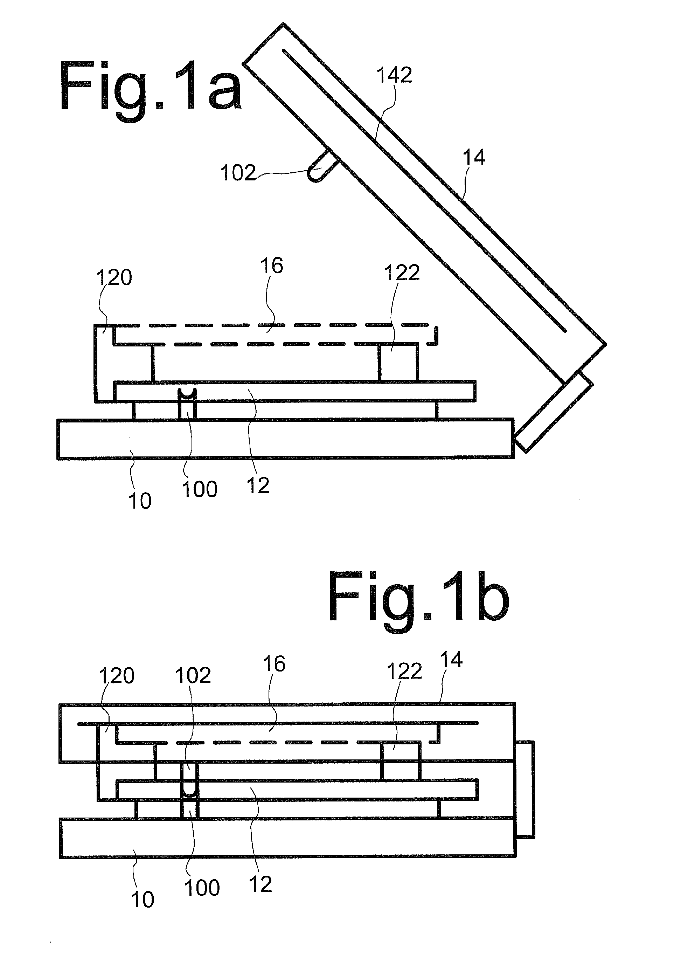

Figure 1a, bshows side views of a screen printing device for printing a pattern of material such as solder paste on a printed circuit board (PCB). The screen printing device comprises a bed 10, a platform 12 and a frame 14. A PCB 16 is shown on platform 12.

Figure 1a, b show frame 14 in two different positions relative to bed 10. Frame 14 is connected to bed 10 via a hinge. Figure 1a shows an initial open position wherein frame 14 is oriented at an angle to bed 10. Figure 1b shows a printing position wherein frame 14 is parallel to platform 12. Bed 10 is provided with a first support post 100 with a convex top (e.g. hemispherical or conic). Frame 14 is provided with a corresponding second support post 102 with a concave end that fits over the convex top of support post 100. In the printing position support post 102 rests on first support post 100. The fitting convex and concave shape provides for alignment of frame 14 and bed 10, both in terms of parallel orientation and mutual lateral shift.

Platform 12 is mounted on bed 10. A lift mechanism (not shown) may be provided between platform 12 is mounted and bed 10, for moving platform 12 vertically relative to bed 10. Platform 12 is provided with a support blocks 120 and support posts 122 (only one visible) for PCB 16.

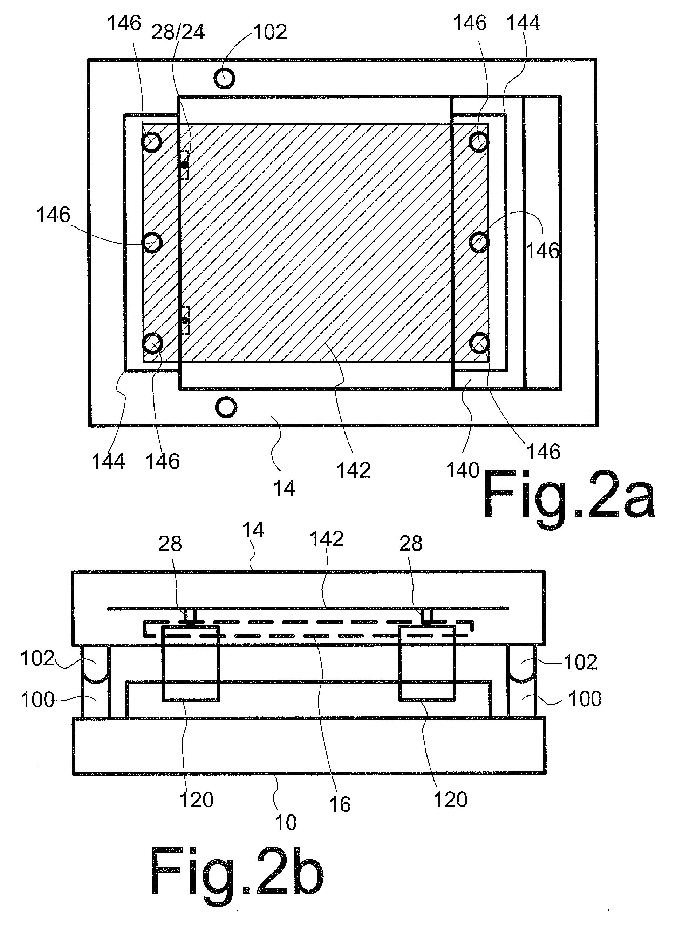

Figure 2a shows a plan view of an embodiment of frame 14. Frame 14 comprises a rectangle of four mutually fixed bars and an adjustable bar 140, which runs parallel to one pair of sides of the rectangle. A mechanism (not shown) is provided for fixing adjustable bar 140 at an adjustable position between the bars of the rectangle.

A printing screen 142 is mounted in frame 14 in a window between three bars of the rectangle and adjustable bar 140. Adjustable bar 140 and the bar of the rectangle that faces it have slots 144 for inserting end portions of printing screen 142 and clamping bolts 146 through the bars to clamp printing screen 142 in slots 144. By way of example three clamping bolts 146 are shown in each of adjustable bar 140 and the bar of the rectangle that faces it. Slots 144 are wider and/or deeper than necessary for fitting printing screen 142, allowing for lateral movement of printing screen 142 within slots 144, relative to frame 14 as long as clamping bolts 146 are not tightened. Pins 28 on printing screen 142 and upper extensions 24 of support block 120 are shown symbolically.

Figure 2b shows a side view from a direction perpendicular to that for figures 1a, b. As can be seen, support posts 100, 102 are provided on either side of platform 12. Herein frame 14 is shown lowered to a position wherein upper support posts 102 from frame 14 rest in lower support posts 110 on bed 10.

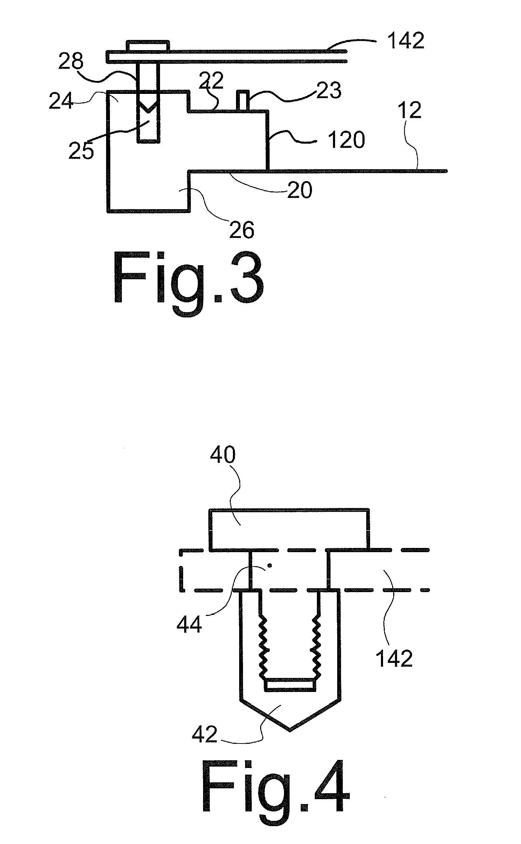

Figure 3 shows a support block 120 and part of printing screen 142 in more detail. Support block 120 has a flat, horizontal lower support surface 20 for supporting support block 120 on platform 12. Support block 120 has a flat, horizontal upper support surface 22 for supporting PCB 16 on support block 120. Support block 120 has upper and lower extensions 24, 26 rising at right angles from the upper and lower support surface 22, 20 respectively. Upper and lower extensions 24, 26 form stops for movement of PCB 16 relative to support block 120 and of support block 120 relative to platform 12 respectively.

Support block 120 has a vertical cylindrical hole 25 in upper extension 24 and a first pin 23 rising from horizontal upper support surface 22. PCB 16 has holes or slots for receiving first pins 23 from respective ones of the support blocks 120. Printing screen 142 is provided with second pins 28 (one shown) for insertion in the cylindrical holes 25 of the upper extensions 24 of respective ones of the support blocks 120.

In operation printing screen 142 is positioned in frame 14 by inserting end portions of printing screen 142 into slots 144 of the bars of frame 14. Frame 14 is moved into its printing position and printing screen 142 is moved relative to frame until second pins 28 fall into vertical cylindrical holes 25 of support blocks 120. While in this position, clamping bolts 146 are tightened to fix the position of printing screen relative to frame 14. Second pins 28 may have a convex tip (e.g. conical) to facilitate the relative movement. Once clamping bolts 146 are tightened, the device is ready for printing.

Prior to printing on a PCB 16, PCB 16 is placed on support blocks 120 and support posts 122 with the holes or slots receiving first pins 23. Frame 14 is moved to its printing position, moving support posts 100, 102 into contact with each other. Support posts 100, 102 ensure a predetermined relative alignment of frame 14 and bed 10, as shown in figures 1a and 2b. Initially, when frame is moved to the printing position, platform 12 is at a relatively low position, where printing screen 142 does not yet contact PCB 16. Second pins 28 need not yet have entered support blocks 120.

Next platform 12 is moved up (e.g. with the lift), bringing PCB 16 into contact with printing screen 142. As a result cylindrical holes 25 of the upper extensions 24 of the support blocks 120 are also moved, so that they will receive second pins 28 on printing screen 142. Since printing screen 142 has been aligned in advance second pins 28 will not stop against the upper surface of support block 120. After printing screen 142 has been brought into contact with PCB 16, printing material (for example solder paste) is applied to printing screen 142 and transferred to PCB 16 through openings in printing screen 142. Subsequently, platform 12 may be moved down again. Preferably, the height of upper extension 24 is selected so low that the upper surface of PCB 16 is flush with the surface of upper extension 24 or higher. In this way contact between printing screen 142 and PCB 16 is ensured when platform 12 is moved up.

When a designer defines the patterns that have to be applied to PCB 16 with printing screen 142, the position of second pins 28 on printing screen 142 relative to the pattern is also defined. The fixed relative positions of cylindrical holes 25 with respect to first pins 23 and the position of the holes or slots on PCB that receive first pins 23 define the position of the PCB relative to printing screen 142 after printing screen 142 has been fixed in frame 14 with second pins 28 in vertical cylindrical holes 25. Placement of the edge of PCB 16 against the side of upper extensions 24 may also be used to fix the position of PCB 16. Slots in PCB 16 that receive first pins 23 may be configured to allow movement of PCB 16 towards upper extensions 24, without allowing lateral movement.

Figure 4 shows a detail of printing screen 142, with a bolt 40 and a bus 42 with an internal thread. Bolt 40 extends through a hole in the surface of printing screen 142 and bus 42 is screwed onto bolt 40. The diameter of neck 44 of bolt 40 fits tightly in the hole through printing screen 142 and in a corresponding part of bus 42. Bolt 40 and bus 42 form second pin 28 in an accurately reproducible spatial relation with the printing pattern in printing screen 142.

In the illustrated embodiment first and second support post 100, 102 provide for reproducible alignment of frame 14 and bed 10 in the printing position and therefore of platform 12 and PCB 16 with printing screen 142. Second pins 28 enter vertical cylindrical holes 25 due to this alignment by first and second support post 100, 102. Alternatively, first and second support post 100, 102 could be omitted so that second pins 28 and vertical cylindrical holes 25 provide for alignment at least in the lateral directions parallel to the surface of printing screen 142. However use of support posts 100, 102 for alignment provides for a more robust alignment during printing, without exerting forces on printing screen 142 via second pins 28, which could lead to wear. In an embodiment on or both of support posts 100, 102 may be height adjustable. The upper support post 102 may extend through frame 14 for example and have an adjusting knob (not shown) on top, upper support post 102 extending through a screw thread in frame 14 to convert rotation of upper support post 102 into height adjustment. Alternatively, or additionally, lower support post 100 may be adjustable in bed 10. In this way horizontal the alignment of bed 10 and frame 14 can be adjusted.

Although one set of support posts 100, 102 has been shown, it should be appreciated that more than one set may be used on each side to provide alignment. Although upper and lower support posts 100, 102 are shown, it should be realized that one of these may be replaced by a seating on bed 10 or frame 10. Instead of cylindrical posts any other structure may serve as support posts.

Although an embodiment has been shown wherein second pins 28 on printing screen 142 are used that move into vertical cylindrical holes 25, it should be appreciated that alternatively, or additionally one or more protrusions on the upper extensions 24 of support blocks 120 may be used to select the position of printing screen 142 in frame 14, in combination with holes or indentations in printing screen 142. However, the use of pins in printing screen 142 has the advantage that less wear occurs.

Although an embodiment has been shown wherein only one vertical cylindrical hole 25 and only one first pin 23 is provided on each support block 120, it should be appreciated that more than one cylindrical hole 25 and/or more than one first pin 23 may be provided on one or each support block 120. In this case a correspondingly larger number of second pins 28 on printing screen 142 and/or holes or slots in PCB 16 may be used. However, use of one cylindrical hole 25 and one first pin 23 simplifies the use of the device. Although a separate cylindrical hole 25 and first pin 23 have been shown, it should be appreciated that alternatively first pin 23 or an indentation on support block 120 that is used to align PCB 16 may be used to align printing screen 142 at an earlier stage. In this case upper extension 24 may be omitted, or be made so low that first pin 23 extends above the upper surface of upper extension 24 or, if a hole in support surface 22 is used, so that second pin 28 fits into this hole, extending more than the height (if any) of upper extension 24.

Although an embodiment has been shown wherein end portions of printing screen 142 are fixed in slots 144 with clamping bolts 146, it should be appreciated that instead printing screen 142 may be fixed onto a surface of frame 14 and that instead of clamping bolts 146 other types of clamps may be used. Other fixation means may be used. Printing screen 142 may even be fixed to screen with glue for example. Although an embodiment has been shown wherein printing screen 142 is fixed to a first bar of the frame adjacent second pins 28 and a bar parallel to it, it should be appreciated that alternatively, or in addition, printing screen 142 may be fixed to the (long) bars that run perpendicularly to this first bar. It is preferred that second pins 28 and support blocks 120 are located adjacent to one of the bars. But alternatively they may be located adjacent different bars, or even at a distance from the bars of the frame.

Although an embodiment has been shown wherein support blocks 120 are positioned using lower extensions 22 against a side edge of platform 12, it should be appreciated that support blocks 120 may be positioned in other ways, for example with corresponding grooves and slots in support blocks 120 and platform 12.

In an embodiment support blocks 120 may be detachable from platform 12. Each support block 120 may comprise a magnet for example, platform 12 being of permanent magnetic material at least at the position of support blocks 120. Instead of permanent magnetic material one or more electromagnets in support block 120 and/or platform 12 may be used to fix support blocks. Instead of a magnetic attachment, clamps or glue or other fixation means may be used to attach support blocks 120 to platform 12. In operation, support blocks 120 are placed with their lower extensions 22 against a side edge of platform 12. Thus a stable and predictable position is realized. Such a placement leaves a choice of the lateral position of support blocks 120 along the side edge. This can be used to adapt the position of support blocks 120 to the distance between second pins 28 on printing screen 142.

Instead of a plurality of support blocks 120, a single block may be used that extends at least over the distance between second pins 28 on the printing screen 142 that are at least half a width of the printing screen apart. In this embodiment the single block has a plurality of holes with positions corresponding to those of the second pins 28 of the printing screen.

Instead of detachable blocks, or a single detachable block, a block or blocks may be used that are a fixed part of platform 12 However, the use of a plurality of detachable blocks makes the device more flexible.

## Claims

1. A method of printing material on a printed circuit board, using a printing device that comprises a platform for carrying a printed circuit board and a frame for holding a printing screen over the printed circuit board, the method comprising
- providing a plurality of protrusions and/or indentations on an upper surface on at least one printed circuit board support block on the platform;
- providing a plurality of protrusions and/or indentations on the printing screen, of complementary shape with respect to indentations and/or protrusions on said at least one printed circuit board support block;
- repositioning the printing screen relative to the frame when the frame is in a printing position, until the protrusions and/or indentations on the printing screen engage the indentations and/or protrusions on said at least one printed circuit board support block;
- fixing the printing screen relative to the frame while the protrusions and/or indentations on the printing screen are engaged with the indentations and/or protrusions on said at least one printed circuit board support block;
- subsequently placing a printed circuit board on the at least one printed circuit board support block and using the printing screen to print material on the printed circuit board.

2. A printed circuit board printing device comprising
- a platform for supporting a printed circuit board;
- at least one printed circuit board support block on the platform, having a plurality of protrusions and/or indentations, the at least one printed circuit board support block defining a first location for supporting the printed circuit board;
- a frame configured to hold a printing screen at a second location over said first location, with the printing screen exposed to the plurality of protrusions and/or indentations, the frame comprising fixation means for fixing a printing screen relative to the frame, the frame providing for repositioning of the printing screen in the frame when not fixed by said fixation means.

3. A device according to claim 2, wherein the at least one printed circuit board support block has a support surface for supporting a printed circuit board to be printed and a further plurality of further protrusions and/or indentations on said support surface, for engagement with corresponding further indentations and/or protrusions on the printed circuit board.

4. A device according to any one of claims 2 to 3, comprising a printing screen having a plurality of indentations and/or protrusions, of complementary shape with respect to protrusions and/or indentations on said at least one printed circuit board support block.

5. A device according to claim 4, wherein the frame defines a window for exposing the printing screen, the frame comprising a slot, the slot opening towards the window, for receiving an end portion of the printing screen, the slot having a dimension that allows for said repositioning of the printing screen within the slot.

6. A device according to one of claims 2 to 5, wherein the at least one printed circuit board support block comprise a first and second printed circuit board support block, each comprising at least one of the plurality of protrusions and/or indentations.

7. A device according to one of claims 2 to 6, wherein the first and second printed circuit board support block each comprise a hole positioned to receive a pin on the printing screen in a printing position of the device.

8. A device according to one of claims 2 to 7, wherein the first and second printed circuit board support block are provided moveable at least relative to each other on the platform.

9. A device according to one of claims 2 to 8, wherein the at least one printed circuit board support block comprise a detachable printed circuit board support block which is detachable from the platform.

10. A device according to claim 9, wherein the detachable printed circuit board support block comprises a magnet for magnetically fixing the detachable printed circuit board support block to the platform.

11. A device according to any one of claims 2 to 10, comprising engageable alignment means for aligning the frame with the platform, to align the platform and the frame in at least a direction transverse to the protrusions and/or indentations on said at least one printed circuit board support block, the frame and the platform being moveable relative to each other, between a printing position wherein the second location for the printing screen is positioned over the first location for the printed circuit board, and a printed circuit board insertion position wherein the second is removed from the first location, the alignment means being configured to establish engagement before engagement, if any, of the protrusions and/or indentations on said at least one printed circuit board support block with the printing screen, when the frame and the platform are moved relative to each other to the printing position.

12. A device according to any one of claims 2 to 11, comprising
- a device bed;
- support posts for supporting the frame on the device bed a direction perpendicular to a main surface of the printing screen when the printing screen is in said second location;
- a lifting mechanism for moving the platform relative to the device bed in said direction.

13. A device according to claim 12, wherein the frame and the bed are moveable relative to each other, between a printed circuit board insertion position and a printing position, wherein the printing screen is located over the first position for the printed circuit board, the support posts being configured to engage and disengage when the frame and bed are moved into the printing position and the printed circuit board insertion position respectively.

14. A device according to any one of claims 2 to 11, comprising a printed circuit board to be printed at said first location.

15. A printing screen for printing a pattern on a printed circuit board, the printing screen comprising pins extending from a main surface of the printing screen.
